# EUROPÄISCHE PATENTANMELDUNG

(11) **EP 0 718 878 A2**
(43) Veröffentlichungstag der Anmeldung: **26.06.1996**
(21) Anmeldenummer: 95120269.6
(22) Anmeldetag: 21.12.1995
(51) Int. Cl.: H01L 21/48

(54) **Verfahren zur Herstellung von Leiterbahnen auf einem Vertiefungen aufweisenden Substrat**

(30) Priorität: 24.12.1994 DE 4446509
(71) Anmelder: Alcatel SEL Aktiengesellschaft, D-70435 Stuttgart (DE)
(72) Erfinder: Richter, Horst, Dr., D-71032 Böblingen (DE); Springer, Johann, Dr., D-73773 Aichwald (DE); Jörg, Walter, D-70439 Stuttgart (DE)
(74) Vertreter: Pohl, Herbert, Dipl.-Ing

(57) **Zusammenfassung**

Die Erfindung betrifft ein Verfahren zur Herstellung einer Mehrzahl von elektrischen Leitern auf einem Substrat mit einer Mehrzahl von V-Nuten.

Bei einem Ausführungsbeispiel wird auf die gesamte Oberfläche des Substrats eine Folie aus PTFE oder einem ähnlichen Werkstoff auflaminiert. Es werden Löcher in die Folie geätzt. Die Löcher werden metallisiert. Es werden Leiterbahnen erzeugt, welche mit den metallisierten Löchern elektrisch leitend verbunden sind. Die Folie wird im Bereich der Nuten weggeätzt.

Bei einem anderen Ausführungsbeispiel werden die Nuten vorübergehend mit einem Fotolack ausgefüllt und die Leiterbahnen und Konaktflächen nach einem photolithographischen Verfahren hergestellt.

## Beschreibung

Die Erfindung betrifft ein Verfahren zur Herstellung von Leiterbahnen und/oder Kontaktquadern aus einem elektrisch gut leitendem Werkstoff in sehr geringem Abstand zum Ende von in einem Substrat angeordneten Vertiefungen.

In elektronischen Schaltungen, wie optoelektronischen Hybridschaltungen, sind mit elektrischen Kontakten versehene optoelektronische Bauelemente auf einem Substrat aus Silizium angeordnet, an welche Lichtwellenleiter angekoppelt sind. Die Lichtwellenleiter sind in V-Nuten angeordnet. Da die optoelektronischen Bauelemente, wie Halbleiter-Laser oder Dioden das optisch-elektronische Bindeglied darstellen, müssen die zu ihnen führenden elektrischen Leitungen und/oder die Kontakte mit denen sie beispielsweise in Flip-Chip-Technik verbunden sind, in sehr geringem Abstand zum Ende der V-Nuten angeordnet sein. Dieser Abstand liegt beispielsweise in der Größenordnung von 50 µm und die Tiefe der V-Nut bei 700 µm. Die Vertiefungen im Substrat erschweren die Herstellung von Leiterbahnen und/oder Kontaktquadern wegen der erheblichen Unebenheit der Substratoberfläche. Das der Erfindung zugrunde liegende technische Problem besteht deshalb darin, ein Verfahren anzugeben, mit welchem die Leiterbahnen und/oder Kontaktquader bezüglich Größe und Abstand in der erforderlichen Qualität hergestellt werden können.

Dieses technische Problem ist erfindungsgemäß dadurch gelöst, daß die Vertiefungen vorübergehend verschlossen werden und danach die Leiterbahnen bzw. Kontaktquader nach einem photolithographischen Verfahren hergestellt werden.

Wenn die Vertiefungen, beispielsweise die V-Nuten zur Aufnahme der Lichtwellenleiter während der Herstellung der Leiterbahnen und/oder Kontaktquader verschlossen, d.h. die Unebenheiten auf dem Substrat eingeebnet sind, dann ist deren Herstellung mit einem an sich bekannten photolithographischen Verfahren in der erforderlichen Qualität möglich.

Vorteilhafte Einzelheiten der Erfindung sind in den Ansprüchen 2 und 8 enthalten. Sie ist nachstehend anhand der Figuren 1 bis 3 näher erläutert. Es zeigen:
- Fig. 1: die Draufsicht auf ein Substrat, auf welchem ein mit einem Lichtwellenleiter gekoppelter Halbleiterlaser angeordnet ist,
- Fig.2a bis 2g: den Querschnitt durch das Substrat während unterschiedlicher Herstellungsstufen der elektrischen Leiterbahnen bei einem Ausführungsbeispiel und
- Fig. 3a bis 3f: den Querschnitt durch das Substrat während unterschiedlicher Herstellungsstufen der elektrischen Leiterbahnen bei einem anderen Ausführungsbeispiel.

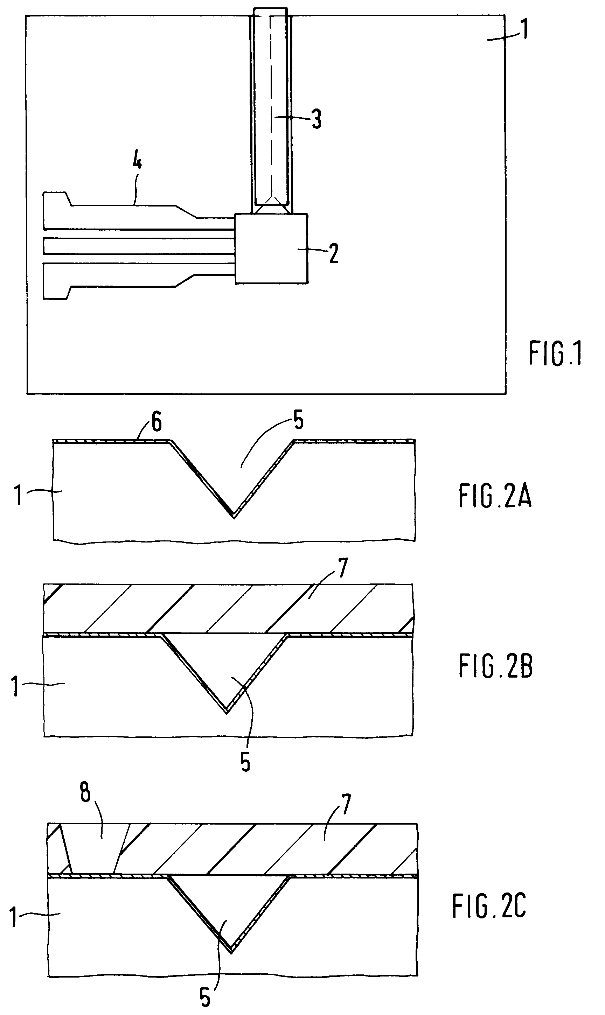

Wie aus Fig. 1 zu erkennen ist, ist auf dem Substrat 1 der Halbleiterlaser 2 oder ein anderes optoelektronisches Bauelement angeordnet, an welcher der Lichtwellenleiter 3, welcher in einer V-Nut liegt, angekoppelt ist. Für den elektrischen Anschluß des Halbleiterlasers 2 sind die Leiterbahnen 4 vorgesehen. Am Ende der Leiterbahnen 4 sind - nicht gezeigte - Kontaktquadern aus einem elektrisch gut leitenden Werkstoff vorgesehen, welche die elektrisch leitende Verbindung zu entsprechenden Kontakten am Halbleiterlaser 2 herstellen.

Fig. 2a zeigt den Querschnitt des Substrats 1 an der Stelle der V-Nut 5 vor dein Beginn der Herstellung der Leiterbahnen oder Kontaktquader. Die Oberfläche des Substrats 1 ist mit einer dünnen Metallschicht 6 von 1µm, beispielsweise aus Gold, bedeckt.

Fig. 2b zeigt den gleichen Querschnitt wie Fig. 2a, nachdem auf der Oberfläche des Substrats 1 eine mit einer Kleberschicht versehene Folie 7 auflaminiert worden ist. Die Folie 7 kann aus PTFE, Polyimid oder einem anderen Werkstoff mit ähnlichen Eigenschaften bestehen und weist eine Stärke zwischen 25 und 200 µm auf. Wegen ihrer Festigkeit überspannt sie die V-Nut oder andere Vertiefungen in dem Substrat.

Fig. 2c zeigt das Substrat 1, nachdem an einer Stelle in der Folie 7 eine bis zur Metallschicht 6 reichende Öffnung 8 erzeugt worden ist, mit deren Hilfe eine Durchkontaktierung zur Metallschicht hergestellt werden soll. Diese Öffnung 8 kann beispielsweise nach Herstellung einer entsprechend lithographisch strukturierten Maske durch reaktives Ionenätzen (RIE-Ätzen) hergestellt worden sein.

Fig. 2d zeigt das Substrat 1, nachdem die Öffnung 8 mit einer Säule 9 aus Metall gefüllt worden ist. Als Metall sind Kupfer oder Nickel geeignet, welche beispielsweise stromlos abgeschieden werden können. Die Herstellung der Säule 9 kann auch durch galvanische Metallabscheidung erfolgen, welches keine Schwierigkeiten bereitet, wenn die Folie aus PTFE besteht und unterhalb der Folie eine geschlossene Metallschicht für die Stromzufuhr vorhanden ist.

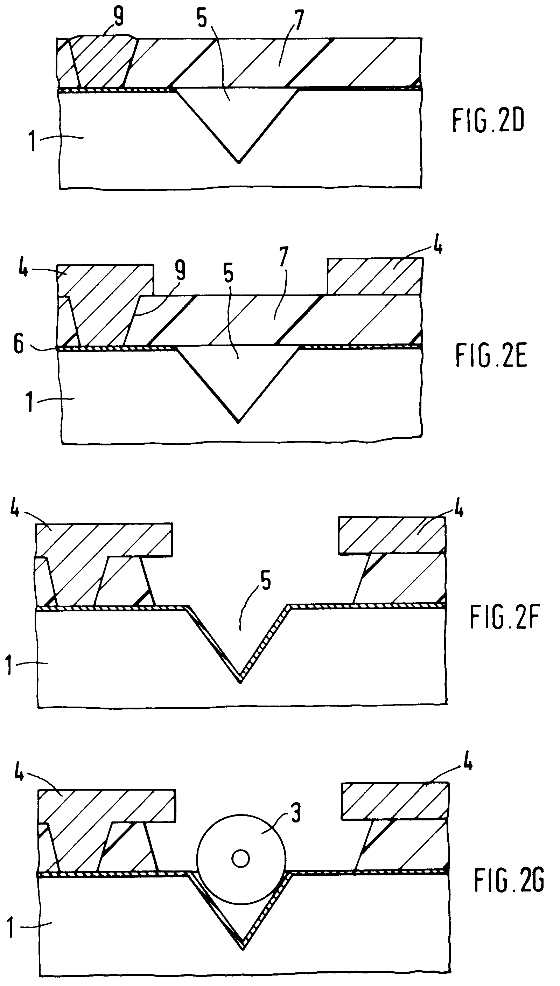

Fig. 2e zeigt das Substrat 1, nachdem auf der Folienoberfläche Leiterbahnen 4 erzeugt worden sind. Diese Leiterbahnen können in an sich bekannter Weise photolithographisch in subtraktiver oder semiadditiver Technik hergestellt worden sein, wobei auch eine Durchkontaktierung über die Säule 9 zur Metallschicht 6 hergestellt werden kann. Es können noch weitere Strukturen, wie Kontaktquader, nach den Verfahren der Dünnschichtmehrlagentechnik in aufeinander folgenden Verfahrensschritten erzeugt werden.

Fig. 2f zeigt das Substrat 1, nachdem die Folie 7 überall dort entfernt worden ist, wo sie nicht von Leiterbahnen 4 bedeckt war welche als Ätzschutz gedient haben. Das Ätzen kann wieder durch das RIE-Ätzverfahren erfolgt sein. Die Leiterbahnen 4 weisen gute Hochfrequenzeigenschaften auf, weil sie teils von Luft oder von der Folie 7 mit einer ebenfalls niedrigen Dielektrizitätskonstante umgeben sind.

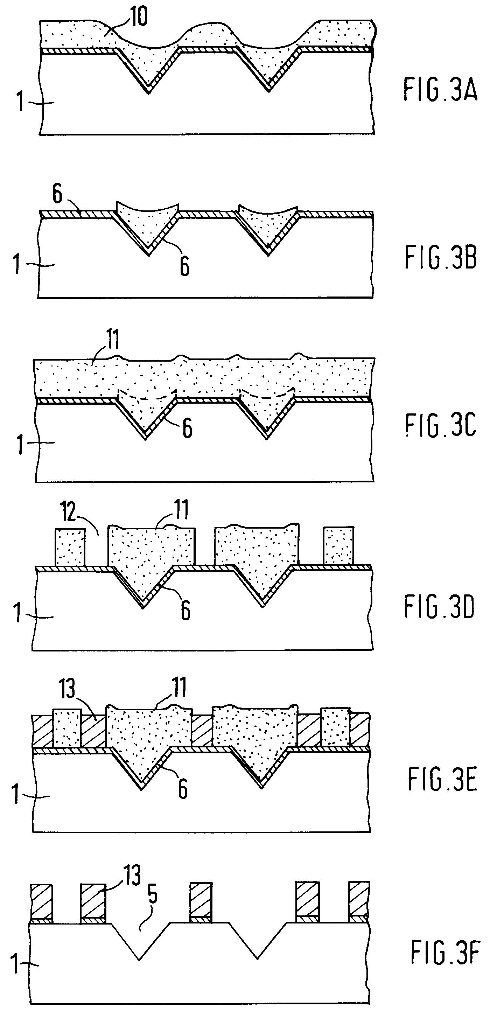

Fig. 2g zeigt nahezu den Endzustand des Substrats 1, nachdem der Lichtwellenleiter 3 nach dem Freilegen der V-Nut 5 in diese eingelegt worden ist. Das Bauelement, beispielsweise ein Halbleiterlaser kann nun mit den Leiterbahnen 4 kontaktiert werden. Dazu dienen beispielsweise - hier nicht gezeigte - Kontaktquader, die in der Weise wie im Ausführungsbeispiel gemäß den Figuren 3c bis 3e hergestellt werden können.

Die Metallschicht 6, die nach diesem Verfahrensschritt das Substrat noch vollständig bedeckt, kann - falls erforderlich - durch weitere lithographische Verfahrensschritte ebenfalls strukturiert werden, wobei jedoch in der nächsten Umgebung der Vertiefungen nicht sehr präzise strukturiert werden kann.

Wenn eine präzise Strukturierung der Metallschicht 6 erforderlich sein sollte, kann die Kunststoffolie in dem gewünschten Muster strukturiert (z.B. durch Laserablation) und als Ätzmaske verwendet werden. Anschließend können eventuell noch vorhandene Reste der Kunststoffolie durch RIE entfernt werden.

Die Figuren 3a bis 3f zeigen das Substrat 1 nach unterschiedlichen aufeinanderfolgenden Verfahrensschritten bei einer anderen Ausführungsform des Verfahrens zur Herstellung der Leiterbahnen und/oder Kontaktquadern.

Fig. 3a zeigt das Substrat 1 mit den V-Nuten und der auf der Oberfläche des Substrats 1 angeordneten Metallschicht, wie dies bereits im Zusammenhang mit Fig. 2 beschrieben worden ist. Im Unterschied zu Fig. 2b ist in Fig. 3a gezeigt, daß die Oberfläche des Substrats 1 mit einer Schicht 10 aus Fotolack bedeckt ist, welche durch Walzenauftrag, mittels Siebdruck oder dgl. erzeugt worden ist.

Fig. 3b zeigt das Substrat 1 gemäß Fig. 3a, nachdem die Fotolackschicht 10 belichtet und entwickelt worden ist und der belichtete und entwickelte Teil der Fotolackschicht entfernt worden ist. Dieser Verfahrensschritt ist in der Weise ausgeführt worden daß der sich den V-Nuten befindende Fotolack nicht belichtet, entwickelt und entfernt worden ist.

Fig. 3c zeigt das Substrat 1, nachdem eine neue Schicht 11 aus Fotolack aufgebracht worden ist. Bei dem in Fig. 3d gezeigten Substrat 1 ist die Fotolackschicht 11 durch eine Maske belichtet worden, der belichtete Teil der Fotolackschicht 11 entwickelt und entfernt worden. Es sind die bis auf die Metallschicht 6 reichenden Vertiefungen 12 in der Fotolackschicht 11 entstanden.

Fig. 3e zeigt das Substrat 1, nachdem in den Vertiefungen 12 eine Metallschicht 13 erzeugt worden ist. Bei dem in Fig. 3f gezeigten Substrat 1 ist die Fotolackschicht 11 und ein Teil der Metallschicht 6 durch Differenzätzung entfernt worden.

Es ist aber auch möglich, ausgehend von dem Substrat 1 gemäß Fig. 3b die Leiterbahnen und/oder Kontaktquadern nach einem anderen bekannten photolithographischen Verfahren herzustellen.

## Patentansprüche

1. Verfahren zur Herstellung von Leiterbahnen und/oder Kontaktquadern aus einem elektrisch gut leitendem Werkstoff in sehr geringem Abstand zum Ende von in einem Substrat angeordneten Vertiefungen,
**dadurch gekennzeichnet**, daß die Vertiefungen (5) vorübergehend verschlossen werden und danach die Leiterbahnen (4) bzw. Kontaktquader nach einem photolithographischen Verfahren hergestellt werden.

2. Verfahren nach Anspruch 1,
dadurch gekennzeichnet, daß die Vertiefungen (5) mit einem Fotolack aufgefüllt werden.

3. Verfahren nach Anspruch 1,
dadurch gekennzeichnet, daß die Vertiefungen mit einer Kunststoffolie (7) abgedeckt werden.

4. Verfahren nach den Ansprüchen 1 und 3,
dadurch gekennzeichnet, daß aus den Leiterbahnen (4) und der Kunststoffolie (7) eine Hochfrequenzleitung in Form einer Mikrostreifenleiter-Anordnung gebildet wird.

5. Verfahren nach den Ansprüchen 1 bis 3,
dadurch gekennzeichnet, daß nach der Herstellung der Leiterbahnen (4) auf diesen Kontaktquader hergestellt werden.

6. Verfahren nach den Ansprüchen 1 und 3 bis 5,
dadurch gekennzeichnet, daß als Werkstoff für die Kunststoffolie ein Polyimid verwendet wird.

7. Verfahren nach den Ansprüchen 1 und 3 bis 5,
dadurch gekennzeichnet, daß als Werkstoff für die Kunststoffolie ein Fluorpolymer verwendet wird.

8. Verfahren nach den Ansprüchen 1 und 3 bis 7,
dadurch gekennzeichnet, daß die Kunststoffolie als Maske bei der Strukturierung der Metallschicht (6) verwendet wird.
